(19) Europäisches Patentamt
European Patent Office
Office européen des brevets

(11) **EP 4 502 647 A1**

(12) **EUROPEAN PATENT APPLICATION**

(43) Date of publication:
**05.02.2025 Bulletin 2025/06**

(21) Application number: **24183082.7**

(22) Date of filing: **19.06.2024**

(51) International Patent Classification (IPC):
*G01S 7/35* (2006.01)   *G01S 13/931* (2020.01)
*G01S 13/42* (2006.01)   *H03B 27/00* (2006.01)
*H03D 7/14* (2006.01)   *H03F 3/45* (2006.01)
*H03H 11/16* (2006.01)   *H03K 5/13* (2014.01)

(52) Cooperative Patent Classification (CPC):
**G01S 7/35; G01S 13/426; G01S 13/931;
H03B 19/03; H03B 19/05; H03B 19/14;
H03F 3/45183; H03H 11/16; H03K 5/13**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(30) Priority: **04.08.2023 IT 202300016764**

(71) Applicant: **STMicroelectronics International N.V.
1228 Plan-les-Ouates, Geneva (CH)**

(72) Inventors:
• **PAPOTTO, Giuseppe**
  **I-95033 Biancavilla (Catania) (IT)**
• **PARISI, Alessandro**
  **I-95126 Catania (IT)**
• **PALMISANO, Giuseppe**
  **I-95030 S.Giovanni La Punta (Catania) (IT)**

(74) Representative: **Buzzi, Notaro & Antonielli d'Oulx
S.p.A.
Corso Vittorio Emanuele II, 6
10123 Torino (IT)**

(54) **A SIGNAL PROCESSING METHOD, CORRESPONDING CIRCUIT, DEVICE, RADAR SYSTEM AND VEHICLE**

(57)     A method, comprising: receiving ($IN_1$) a first input signal ($V_1$) oscillating at an input frequency; receiving ($PC_1$) a first set of control signals ($B_1$); receiving ($IN_2$) a second input signal ($V_2$) oscillating at the input frequency and in quadrature with the first input signal ($V_1$); receiving ($PC_2$) a second set of control signals ($B_2$); applying first signal processing (121) to the first input signal ($V_1$) and to the first set of control signals ($B_1$), providing a first output signal ($O_1$) as a result, the first output signal ($O_1$) oscillating at a first output frequency based on (e.g., multiple of) the input frequency ($f_0$) and having an output signal amplitude based on the amplitude of at least one first control signal ($I_{B1}$) in the first set of control signals ($B_1$); applying second signal processing (122) to the second input signal ($V_2$) and to the second set control signals ($B_2$), providing a second output signal ($O_2$) as a result, the second output signal ($O_2$) oscillating at the first output frequency and having an output signal amplitude based on the amplitude of at least one second control signal ($I_{B2}$) in the second set of control signals ($B_2$); based on the first output signal ($O_1$) and the second output signal ($O_2$), providing (14) a further output signal (OUT) as a result. The further output signal (OUT) oscillates at an output signal frequency equal to the first output frequency and has a phase shift based on a ratio of signal amplitudes of at least one control signal ($I_{B1}$) in said first set of control signals ($B_1$) and of at least one control signal ($I_{B2}$) in said second set of control signals ($B_2$).

FIG. 1

**(Cont. next page)**

# FIG. 1

## Description

<u>Technical field</u>

The description relates to circuits and systems for providing radio-frequency (briefly, RF) signals, such as frequency multiplier circuitry, for instance.

One or more embodiments may be applied, e.g., in automotive radar applications.

<u>Background</u>

Increasingly higher demand for driving safety standards has led to a widespread adoption of Advanced Driver Assistance System (briefly, ADAS) in the automotive field.

ADAS implement control systems which may exploit several sensors, e.g., radar sensors, to provide functionalities such as adaptive cruise control, collision-avoidance, park assist, for instance.

A vehicle may comprise a plurality of radar sensors to facilitate detecting position and speed of objects nearby. For instance, the radar sensors may operate by transmitting a signal, e.g., millimeter-wave (1 millimeter=1 mm= $10^{-3}$ m) signal (77 GHz according to ETSI standard, where 1 GHz= 1 GigaHertz= $10^9$ Hz), and receiving an echo signal, reflected by the object nearby.

In a radar operating at the mm-wave range, a resonator-based approach (i.e., LC tank) facilitates to reduce power consumption in generating the signals to transmit.

At the same time, beam-scanning resolution is a figure of merit of radar systems, for instance for those configured to be equipped on-board autonomous driving vehicles.

In order to provide high beam-scanning resolution, the phase shifting accuracy of a phase-shifter becomes relevant in the signal processing chain of the radar system.

Phase shifters are mainly classified into active and passive phase shifter.

Passive phase shifters employ variable physical delay based on switchable filters or a tunable transmission line.

Document [1] M. Jung and B. -W. Min, "A Compact Ka-Band 4-bit Phase Shifter With Low Group Delay Deviation," in IEEE Microwave and Wireless Components Letters, vol. 30, no. 4, pp. 414-416, April 2020, doi: 10.1109/LMWC.2020.2975108 discusses a compact Ka-band 4-bit switch-type phase shifter with low group delay deviation (GDD) using 28-nm CMOS technology, wherein a magnetically coupled all-pass network (APN) configuration is employed to achieve both equal and flat group delay characteristics versus frequency at each phase state.

Document [2] W. H. Woods, A. Valdes-Garcia, H. Ding and J. Rascoe, "CMOS millimeter wave phase shifter based on tunable transmission lines, "Proceedings of the IEEE 2013 Custom Integrated Circuits Conference, San Jose, CA, USA, 2013, pp. 1-4, doi: 10.1109/CICC.2013.6658442 discusses a tunable transmission line (t-line) structure, featuring independent control of line inductance and capacitance. The t-line provides variable delay while maintaining relatively constant characteristic impedance using direct digital control through FET switches, where a 50 GHz RF-phase shifter for phased-array applications is implemented in a 32 nm SOI process attaining state-of-the-art performance.

Document [3] S. Kishimoto, I. Ando, M. Kohtani, N. Hasegawa, T. Arai and S. Yamaura, "A 79GHz 13.5dBm P sat at 150° C transmitter with compact local phase shifter in 40nm CMOS for automotive radar", Proc. IEEE 20th Topical Meeting Silicon Monolithic Integr. Circuits RF Syst. (SiRF), pp. 66-69, 2020 discusses a passive phase shifter in which the output phase can be changed by adjusting the impedance of a reflective load.

Active phase shifters comprise a vector modulator configured to provide a variable output phase by performing a (e.g., weighed) sum of orthogonal I/Q signals, wherein the phase of the output signal can be changed by adjusting a gain of variable gain amplifiers in the processing chain.

Document [4] Shimura, Toshihiro et al. "A 76-81 GHz active phase shifter for phased array automotive radar in 65nm CMOS." 2013 European Microwave Integrated Circuit Conference (2013): 252-255 discusses an active phase shifter in 65nm CMOS for phased array radar systems, covering dual radar bands of 76 GHz and 79 GHz, which achieves 360-degree phase variation using a vector combining method. 4-phase quadrature signals are produced using a coupled-line type 90-degree hybrid circuit and two single-to-differential amplifiers designed with a neutralization technique for stability and gain enhancement in wider frequency range.

Document [5] F. Akbar and A. Mortazawi, "A frequency tunable 350° analog CMOS phase shifter with an adjustable amplitude," in IEEE Transactions on Circuits and Systems II: Express Briefs, vol. 64, no. 12, pp. 1427-1431, Dec. 2017, doi: 10.1109/TCSII.2017.2766662 discusses a vector sum phase shifter topology utilizing a current mode R-C poly phase filter along with several current steering variable gain amplifiers, in which the phase shifter can generate a signal with a tunable phase and magnitude in a phased array, thereby providing a better control over the beamwidth and sidelobe levels.

Document [6] B. Dou et al., "A 4-10 GHz Programmable CMOS Vector-Sum Phase Shifter for a Two-Channel Transmitter," in IEEE Transactions on Circuits and Systems II: Express Briefs, vol. 69, no. 9, pp. 3699-3703, Sept. 2022, doi: 10.1109/TCSII.2022.3173042 discusses a 6-bit full-span programmable vector-sum phase shifter, in which a transformer-based matching network is used to match the PPF-based I/Q generator to the variable gain amplifier-based vector-modulator (VGA-based VM), which eliminates the performance degradation due to impedance mismatch, and where the proposed phase shifter integrated in a two-channel transmitter implemented in a 180-nm CMOS process.

Conventional phase shifters suffer one or more of the following drawbacks:

- limited capability to reduce the phase error while operating in the mm-wave range;
- active phase shifter show a limited robustness to PVT variations;
- passive phase shifters involve an increased area footprint on chip, and
- both passive and active phase shifter present a non-negligible power consumption.

Object and summary

An object of one or more embodiments is to contribute in overcoming one or more limits of current technology.
According to one or more embodiments, that object can be achieved via a method having the features set forth in the claims that follow.
One or more embodiments may relate to a corresponding circuit.
One or more embodiments may relate to a corresponding device.
One or more embodiments may relate to a corresponding system.
For instance, a radar system equipped onboard a vehicle may be exemplary of such a system.
The claims are an integral part of the technical teaching provided herein with reference to the embodiments.
One or more embodiments envisage a phase shifter comprising an embedded frequency multiplier functionality.
One or more embodiments facilitate reducing both silicon area occupation and power consumption.
In one or more embodiments, a phase-locked loop and/or other circuit elements are operated at a fraction of the frequency to counter frequency pulling from the power amplifier. This may also relax circuit design constraints and power consumption.
One or more embodiments provide a phase shifter capable to simultaneously performing phase shifting and frequency multiplication operations.
For example, the proposed phase shifter provides an Nth-harmonic of an input signal as an output signal while applying thereto a variable phase shifting (e.g., from 0° to 360°) controlled via a bias current.
In one or more embodiments, the phase shifting operation is independent from the input voltage amplitude and/or the supply voltage, leading to extending circuit robustness over process-voltage-temperature (briefly, PVT) variations.

Brief description of the several views of the drawings

One or more embodiments will now be described, by way of non-limiting example only, with reference to the annexed Figures, wherein:

Figure 1 is a diagram exemplary of a method as per the present disclosure,
Figure 2 is a diagram exemplary of a circuit as per the present disclosure,
Figures 3A, 3B and 3C are diagrams exemplary of frequency multiplication principles underlying one or more embodiments,
Figures 4A, 4B, 4C and 4D are diagrams exemplary of phase shifting principles underlying one or more embodiments,
Figure 5 is a diagram exemplary of a circuit as per the present disclosure,
Figures 6 and 7 are diagrams exemplary of phase and amplitude of signals in one or more embodiments,
Figure 8 is a diagram exemplary of a radar system equipped onboard a vehicle as per the present disclosure.

Corresponding numerals and symbols in the different figures generally refer to corresponding parts unless otherwise indicated.
The figures are drawn to clearly illustrate the relevant aspects of the embodiments and are not necessarily drawn to scale.
The edges of features drawn in the figures do not necessarily indicate the termination of the extent of the feature.

Detailed description

In the ensuing description, one or more specific details are illustrated, aimed at providing an in-depth understanding of examples of embodiments of this description. The embodiments may be obtained without one or more of the specific details, or with other methods, components, materials, etc. In other cases, known structures, materials, or operations are not illustrated or described in detail so that certain aspects of embodiments will not be obscured.

Reference to "an embodiment" or "one embodiment" in the framework of the present description is intended to indicate that a particular configuration, structure, or characteristic described in relation to the embodiment is comprised in at least one embodiment. Hence, phrases such as "in an embodiment" or "in one embodiment" that may be present in one or more points of the present description do not necessarily refer to one and the same embodiment.

Moreover, particular conformations, structures, or characteristics may be combined in any adequate way in one or more embodiments.

The references used herein are provided merely for convenience and hence do not define the extent of protection or the scope of the embodiments.

For the sake of simplicity, in the following detailed description a same reference symbol may be used to designate both a node/line in a circuit and a signal which may occur at that node or line.

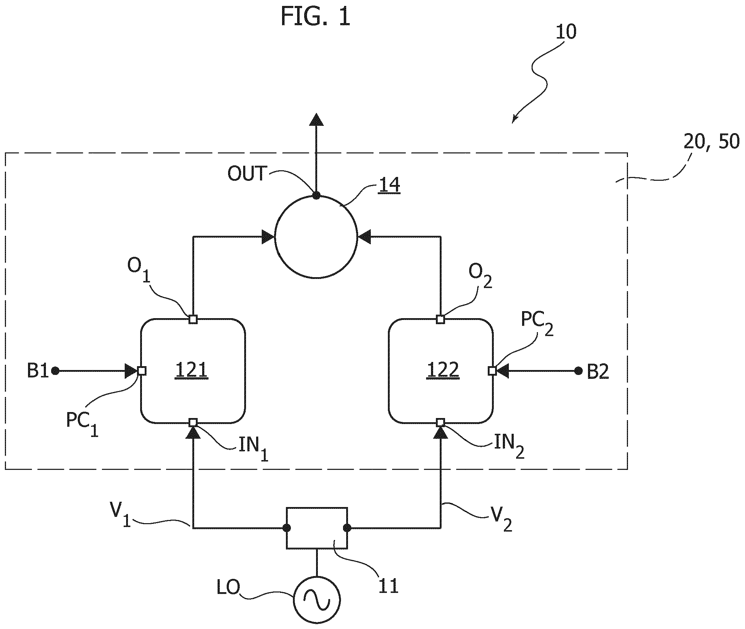

As exemplified in Figure 1, a device 10 as per the present disclosure comprises:

a radio-frequency signal generator RF configured to produce a first radio-frequency signal $V_1$ having a first signal frequency $f_0$,
a quadrature generator 11 configured to provide a second radio-frequency signal $V_2$ as an anteversion of the first radio-frequency signal $V_1$; in other words, the second input signal $V_2$ is in quadrature (that is, shifted by 90°) with the first input signal $V_1$.

For instance, the first $V_1$ and second $V_2$ input signals can be expressed as:

$$V_1 = A \cdot \sin(2\pi f_0)$$

$$V_2 = A \cdot \cos(2\pi f_0)$$

As exemplified in Figure 1, the device 10 further comprises signal processing circuitry 20, 50 comprising:

a first frequency converter circuit 121 comprising a first input node $IN_1$ coupled to the RF signal generator and configured to receive the first input signal $V_1$ therefrom, the first frequency converter circuit 121 further comprising a first control node $PC_1$ configured to set a first control signal B1 (e.g., a first biasing current signal) and a first output node $O_1$ configured to provide an output signal whose output signal frequency and phase are based on the first input signal $V_1$ and the amplitude/intensity on the first control signal B1, as discussed in the following;
a second frequency converter circuit 122 comprising a second input node $IN_2$ coupled to the RF signal generator and configured to receive the second input signal $V_2$ therefrom, the second frequency converter circuit 122 further comprising a second control node $PC_2$ configured to set a second control signal $B_2$ (e.g., a second biasing current signal) and a second output node $O_2$ configured to provide an output signal whose output signal frequency and phase are based on the second input signal $V_2$ and the amplitude/intensity on the second control signal B2, as discussed in the following;
an output circuit block 14 (e.g., such as a resonant circuit LC tuned at a harmonic of the input signal frequency $f_0$) coupled to the first 121 and second 122 frequency converter circuits to receive the first $O_1$ and second $O_2$ output signals therefrom (e.g., output current signals $I_{O1}$, $I_{O2}$) and configured to apply signal combination (e.g., superposition or subtraction) thereto, providing a frequency multiplied and phase shifted signal OUT to user circuits.

For instance, the first and the second control signals $B_1$, $B_2$ have different (e.g., signal intensity) values. For instance, the phase shift introduced by the device 10 on the output signal OUT varies (e.g., linearly) as a function of the ratio of the control signal $B_1$, $B_2$.

For instance, a first output signal $O_1$ produced by the first frequency converter circuit 121 and a second output signal $O_2$ produced by the second frequency converter circuit 122 can be expressed as:

$$O_1 = B_1 \cdot \sin(2\pi N f_0)$$

$$O_2 = B_2 \cdot \cos(2\pi N f_0)$$

where N is the frequency multiplication factor.

For instance, the further output signal OUT produced by the output circuit block 14 as a result of combining (e.g., superimposing or subtracting) the output signals $O_1$, $O_2$ can be expressed as:

$$OUT = B \cdot \sin(2\pi N f_0 + \theta)$$

where

B is the root mean square of the control signals $B_1$ and $B_2$, (i.e., $\sqrt{B_1^2 + B_2^2}$) and
$\Theta$ is a phase-shift of the output signal.

For the sake of simplicity, one or more embodiments are discussed herein mainly with reference to switches comprising n-channel MOSFET switches, being otherwise understood that such a type of switch is purely exemplary and in no way limiting. One or more embodiments may employ p-channel MOSFET or BJT or virtually any other type of switch known per se.

A method as exemplified herein comprises:

receiving $IN_1$ a first input signal $V_1$ oscillating at an input frequency $f_0$;
receiving $PC_1$ a first set of control signals $B_1$;
receiving $IN_2$ a second input signal $V_2$ oscillating at the input frequency and in quadrature with the first input signal;
receiving $PC_2$ a second set of control signals $B_2$;
applying first signal processing 121; 521 to the first input signal and to control signals in the first set of control signals, providing a first output signal $O_1$ as a result, the first output signal oscillating at an output frequency based on the input frequency and having an output signal amplitude based on the amplitude of at least one first control signal $I_{B1}$ in the first set of control signals;
applying second signal processing 122; 522 to the second input signal and to control signals in the second set of control signals, providing a second output signal $O_2$ as a result, the second output signal oscillating at a second output frequency equal to the first output frequency and having an output signal amplitude based on the amplitude of at least one second control signal $I_{B2}$ in the second set of control signals;
based on the first output signal and the second output signal, providing 14 a further output signal OUT oscillating at an output signal frequency equal to the first output frequency and having a phase shift based on a ratio of signal amplitudes of at least one control signal in said first set of control signals and of at least one control signal in said second set of control signals.

As exemplified herein, control signals in the first $B_1$ and second $B_2$ set of control signals comprise biasing current signals $I_{B1}$, $I_{B2}$ and the further output signal OUT has a phase shift $\Theta$ based on a ratio of current intensities of at least one biasing current signal in said first set of control signals and of at least one biasing current signal in said second set of control signals.

A circuit 20; 50 as exemplified herein comprises:

a first set of input nodes $IN_{11}$, $IN_{21}$; $IN_{23}$, $IN_{14}$ configured to receive a first input signal $V_1$ oscillating at an input frequency $f_0$;
a first set of control nodes $PC_1$; $PC_{12}$, $PC_{34}$ configured to receive a first set of control signals $B_1$;
a second set of input nodes $IN_{12}$, $IN_{22}$; $IN_{32}$, $IN_{41}$ configured to receive a second input signal $V_2$ oscillating at the input frequency and in quadrature with the first input signal;
a second set of control nodes $PC_2$; $PC_{21}$, $PC_{34}$ configured to receive a second set of control signals $B_2$;
signal processing circuitry 121, 122; 521, 522 coupled to the first set of input nodes, to the first set of control nodes, to the second set of input nodes and to the second set of control nodes and having a further output circuit block 14, wherein the signal processing circuitry is configured to provide a further output signal OUT at said further output node according to the method as exemplified herein, the further output signal oscillating at an output signal frequency equal to the first output frequency and having a phase shift based on a ratio of signal amplitudes of at least one first control signal in said first set of control signals and of at least one second control signal in said second set of control signals.

The circuit 20; 50 as exemplified herein can be included in a device 10 further comprising a frequency synthesizer LO, 11 coupled to the circuit and configured to provide thereto the input signals oscillating at the input frequency.

For instance, the frequency synthesizer LO, 11 is configured to provide said input signals oscillating at the input frequency such that the output frequency of the further signal lies in the millimeter wavelength range.

A system as exemplified herein comprises:

**EP 4 502 647 A1**

a device 10 as per the present disclosure;
a power amplifier 180 coupled to the circuit and configured to receive the further output signal OUT therefrom, the power amplifier configured to amplify the further output signal and to provide an amplified output signal TX as a result, and
a transmitter antenna 20 coupled to the power amplifier and configured to transmit the amplified output signal. For instance, the system includes a vehicular radar system.

As exemplified herein, a vehicle V can be equipped with a vehicular radar system comprising:

a receiver antenna 22 configured to receive an echo signal based on the transmitted amplified output signal,
a mixer stage 28 coupled to the circuit as per the present disclosure, the mixer stage configured to apply frequency mixing to the further output signal and to the echo signal, producing a mixed signal as a result.

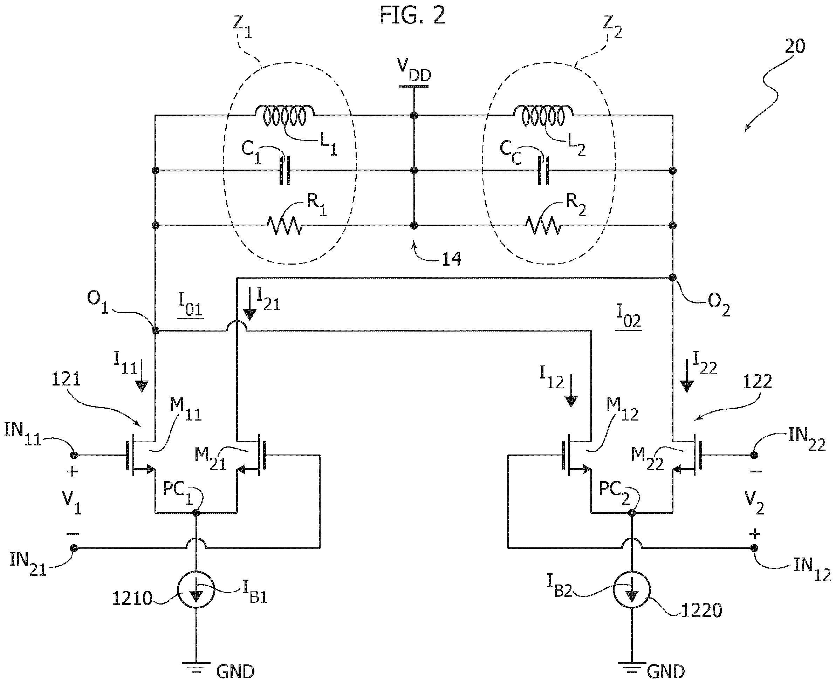

In a first exemplary scenario illustrated in Figure 2, signal processing circuitry 20 as per the present disclosure comprises:

a first (e.g., fully) differential pair of switches $M_{11}$, $M_{21}$ comprising a first (e.g., n-channel MOSFET) switch $M_{11}$ and a second (e.g., n-channel MOSFET) switch $M_{21}$ configured to have the first input signal $V_1$ applied among switch control nodes $IN_{11}$, $IN_{21}$ and coupled to a first biasing (e.g., current) signal generator 1210 referred to ground GND to receive a first biasing (e.g., current) signal $I_{B1}$ therefrom, the first differential pair of switches $M_{11}$, $M_{21}$ configured to provide a differential output signal among differential output nodes $O_1$, $O_2$; for instance, the first switch Mu has a first control node $IN_{11}$, a first output node $O_1$ and a first source node $PC_1$ coupled to a second source node of a second switch $M_{21}$ which has a respective second control node $IN_{21}$ and second output node $O_2$;
a second (e.g., fully) differential pair of switches $M_{12}$, $M_{22}$ comprising a third (e.g., n-channel MOSFET) switch $M_{12}$ and a fourth (e.g., n-channel MOSFET) switch $M_{22}$ configured to have the second input signal $V_2$ applied among switch control nodes $IN_{12}$, $IN_{22}$ and coupled to a second biasing (e.g., current) signal generator 1220 referred to ground GND to receive a second biasing (e.g., current) signal $I_{B2}$ therefrom, the second differential pair of switches $M_{12}$, $M_{22}$ configured to provide a differential output signal among differential output nodes $O_1$, $O_2$; for instance, the third switch $M_{12}$ has a third control node $IN_{12}$, a third output node and a third source node $PC_2$ coupled to a fourth source node of the fourth switch $M_{22}$ which has a respective fourth control node $IN_{22}$ and fourth output node.

As exemplified in Figure 2, the first output node $O_1$ of the first differential pair Mu, $M_{21}$ is coupled to the third output node of the second differential pair $M_{12}$, $M_{22}$ while the second output node $O_2$ of the first differential pair $M_{11}$, $M_{21}$ is coupled to the fourth output node of the second differential pair $M_{12}$, $M_{22}$.

As exemplified in Figure 2, the first 121 and second 122 frequency converter circuits are coupled to a set of load circuits $Z_1$, $Z_2$ comprising:

a first load circuit $Z_1$ comprising a first RLC network, e.g., comprising a first resistive element $R_1$ in parallel to a first capacitive element $C_1$ and to a first inductive element $L_1$;
a second load circuit $Z_2$ comprising a second RLC network, e.g., comprising a second resistive element $R_2$ in parallel to a second capacitive element $C_2$ and to a second inductive element $L_2$.

As exemplified in Figure 2, the load circuits $Z_1$, $Z_2$ are coupled to a biasing node VDD configured to provide a supply voltage VDD and have a circuit output nodes $O_1$, $O_2$ configured to provide an output signal OUT as a combination (e.g., superposition) of the differential output signals $I_{O1}$, $I_{O2}$ provided by the frequency converter circuits 121, 122, the output signal OUT having a frequency based on (e.g., multiple of) the input frequency $f_0$ of the input signals $V_1$, $V_2$.
In order to do so, the passive electrical components $L_1$, $C_1$ and $L_2$, $C_2$ in the first $Z_1$ and second $Z_2$ load circuits are tuned at a desired N-th harmonic of the input signal frequency $f_0$, based on the relation between resonant frequency and capacitance/inductance which may be expressed as $\omega = 1/\sqrt{LC}$.
As exemplified in Figure 2, the intensities $I_{O1}$, $I_{O2}$ of electrical currents generated by the current generators 1210, 1220 may be varied by the user depending on the application. For instance, setting different intensity values for the electrical currents $I_{O1}$, $I_{O2}$ introduces a phase difference between signals output from the first frequency converter circuit 121 and the second frequency converter circuit 122, as discussed in the following.
For instance, the phase shift is a result of the combination (e.g., superposition or difference) at the output circuit block 14 (e.g., implemented via the resonant loads $Z_1$, $Z_2$) of the output current signals produced by each differential circuit 121, 122.
A method of driving the circuit 20 as per the present disclosure comprises:

driving the first differential pair $M_{11}$, $M_{21}$ by applying the first input signal $V_1$ at the control nodes $IN_{11}$, $IN_{21}$ of the first differential pair $M_{11}$, $M_{21}$, alternatively making conductive a current flow path through the first switch $M_{11}$ while making non-conductive a current flow path through the second switch $M_{21}$;

driving the second differential pair $M_{12}$, $M_{22}$ by applying the second input signal $V_2$ (which is in quadrature with the first input signal $V_1$) at the control nodes $IN_{12}$, $IN_{22}$ of the second differential pair $M_{12}$, $M_{22}$, alternatively making conductive a current flow path through the fourth switch $M_{22}$ while making non-conductive a current flow path through the third switch $M_{12}$.

As a result, the first biasing current signal $I_{B1}$ generated by the first current generator 1210 and the second biasing current signal $I_{B2}$ generated by the second current generator 1220 are each multiplied by a square wave of unitary amplitude.

Therefore, a first output current signal $I_{O1}$ comprises a square wave output comprising odd harmonics of the first input signal $V_1$.

$$I_{o1}=I_{11}-I_{21}=\frac{4}{\pi}\left[\sin(\omega_0 t)+\frac{1}{3}\sin(3\omega_0 t)+\frac{1}{5}\sin(5\omega_0 t)+\ldots+\frac{1}{(2N+1)}\sin((2N+1)\omega_0 t)\right]\cdot I_{B1}$$

where

$I_{B1}$ is the biasing current provided by the first current generator 1210.

Similarly, a second output current signal $I_{O2}$ comprises a square wave output comprising odd harmonics of the second input signal $V_2$ and can be expressed as:

$$I_{o2}=I_{12}-I_{22}=\frac{4}{\pi}\left[\cos(\omega_0 t)+\frac{1}{3}\cos(3\omega_0 t)+\frac{1}{5}\cos(5\omega_0 t)+\ldots+\frac{1}{(2N+1)}\cos((2N+1)\omega_0 t)\right]\cdot I_{B2}$$

As exemplified in Figure 2, the LC resonant loads Z 1, Z2 filter the undesired (odd) harmonics.

As exemplified in Figures 1 and 2, a frequency multiplier circuit 10, 50 having an odd multiplication factor of $(2N+1)$ can be obtained by tuning the LC resonant load $Z_1$, $Z_2$ at the $(2N+1)$-th off harmonics of the input signal $V_1$, which may be expressed as:

$$I_{oi}=I_{o1i}-I_{o2i}=\frac{4}{\pi}\left[\frac{1}{2N+1}\sin\big((2N+1)\omega_0 t\big)\right]\cdot I_B$$

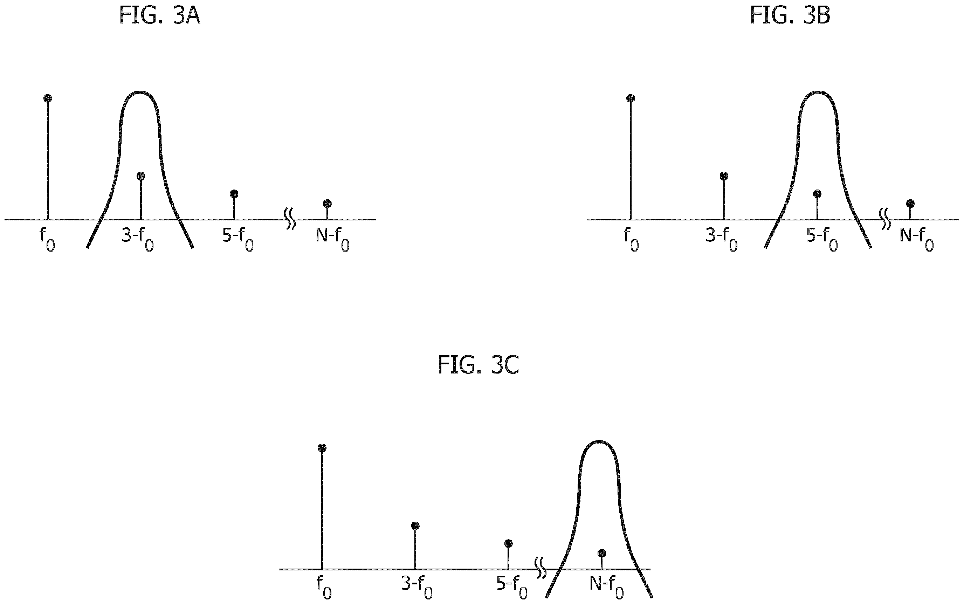

Figures 3A-3C are diagrams exemplary of a spectral content of the frequency multiplied signal at various multiples of the input signal frequency $f_0$.

For instance, a frequency multiplier circuit 10, 20 having multiplication factor of three can be obtained by tuning the LC resonator at the 3rd harmonics of the input signal Vi. In such an exemplary case, the i-th differential output signal $I_{Oi}$ can be expressed as:

$$I_{oi}=I_{o1i}-I_{o2i}=\frac{4}{\pi}\left[\frac{1}{3}\sin(3\omega_0 t)\right]\cdot I_B$$

For instance, if the input signal Vi has an input signal frequency f0 about 26 GHz, a multiplier circuit 20 with multiplication factor of 3 can provide an output signal OUT having an output signal frequency four about 78 GHz.

Figure 3A is a diagram exemplary of a spectral content of the frequency multiplied signal at frequency multiple three times the input signal frequency $f_0$.

In a further exemplary scenario, a frequency multiplier by five is obtained by tuning the LC resonator at the 5th harmonic of the input signal Vi. In such an exemplary case, the i-th differential output signal $I_{O1}$ can be expressed as:

$$I_{oi}=I_{o1i}-I_{o2i}=\frac{4}{\pi}\left[\frac{1}{5}\sin(5\omega_0 t)\right]\cdot I_B$$

Figure 3B is a diagram exemplary of a spectral content of the frequency multiplied signal at frequency multiple five times the input signal frequency $f_0$.

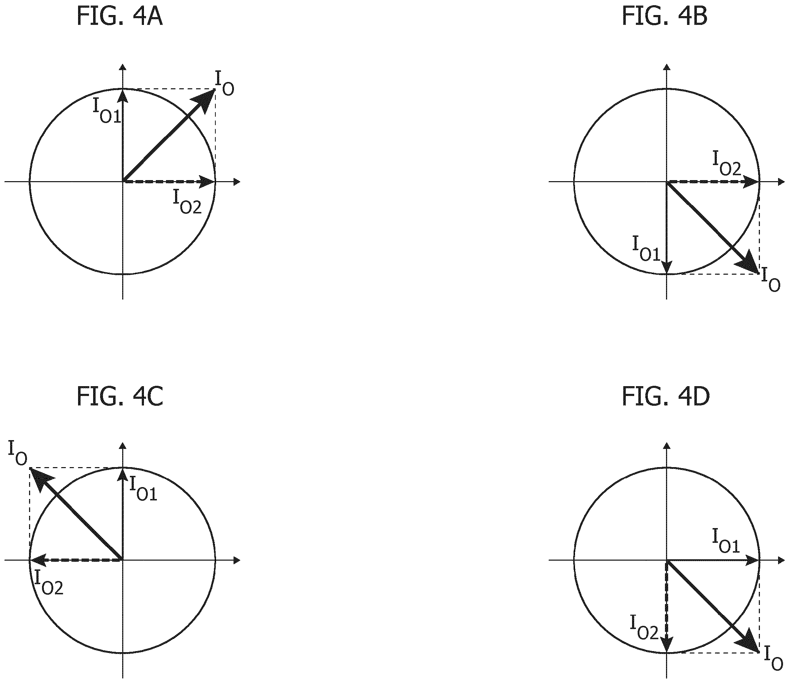

As exemplified in Figures 4A-4B, a differential output current of the two circuit cells which receive input signals $V_1$, $V_2$ in quadrature therebetween comprises of sum of two orthogonal vectors $I_{O1}$, $I_{O2}$ whose intensities can be modulated by changing the biasing currents $I_{B1}$, $I_{B2}$ provided by the respective biasing current generators 1210, 1220.

For instance, the current intensities of output signals $I_{O1}$, $I_{O2}$ may be expressed as:

$$I_{o1} = I_{o11} - I_{o21} = \frac{4}{\pi}\left[\frac{1}{N}\sin\big((2N+1)\omega_0 t\big)\right]\cdot I_{B1}$$

$$I_{o2} = I_{o12} - I_{o22} = \frac{4}{\pi}\left[\frac{1}{N}\cos\big((2N+1)\omega_0 t\big)\right]\cdot I_{B2}$$

A current intensity of the output current signal $I_O$ can be expressed as a sum of the output current signals $I_{O1}$, $I_{O2}$, such as:

$$I_o = I_{o1} + I_{o2} = \frac{4}{\pi N}\left[\sin\big((2N+1)\omega_0 t\big)\cdot I_{B1} + \cos\big((2N+1)\omega_0 t\big)\cdot I_{B2}\right]$$

As exemplified in Figures 1 and 2, an output voltage signal OUT is equal to a differential voltage at nodes O1 and O2. As exemplified in Figure 2, an output voltage can be expresses as OUT = Io x R where Io is the output current and R may be expressed as R = R1+R2, in case the resonant networks $L_1 C_1$ and $L_2 C_2$ resonate at a frequency f which is an odd multiple of the input frequency f0, namely f =(2N+1)*fo.

As exemplified herein, a method of operating the circuit 10, 20 comprises performing phase shifting based on differential output signals $I_{O1}$, $I_{O2}$ output by respective circuit units 121, 122. For instance, a sum current $I_O$ (which may be expressed as $I_O = I_{O1} + I_{O2}$) is based on the sum of two vectors IO1, IO2 in quadrature therebetween and having different amplitudes/intensity, thereby varying the phase-shift of the sum signal OUT, $I_O$.

For instance, performing phase shifting comprises setting the ratio of intensities of biasing currents $I_{B1}$, $I_{B2}$ produced by biasing generators 1211, 1221 to have a ratio equal to the tangent of a phase shift angle $\Theta$, providing a linear phase shift of the sum signal OUT, $I_O$ based on differential output signals $I_{O1}$, $I_{O2}$ as a result.

As exemplified in Figure 4A, if the phase shift $\Theta$ to introduce falls in a range 0° to 90°, a ratio of biasing current intensities can be expressed as:

$$\tan\theta = \frac{I_{B1}}{I_{B2}}$$

In other words, the phase shift $\Theta$ of the output signal OUT resulting from a differential voltage signal based on the first output signal $O_1$ and the second output signal $O_2$ is based on a ratio of the signal amplitudes of control signals (e.g., equal to current intensities in case of biasing current signals), which can be expressed as:

$$\theta = \arctan\left(\frac{I_{B1}}{I_{B2}}\right)$$

where arctan is an inverse function of the trigonometric tangent function.

In such an exemplary scenario, a first intensity $I_{B1}$ of the biasing current generated by the first biasing current generator 1211 can be expressed as:

$$I_{B1} = I_B \cdot \cos\theta$$

Still in the exemplary scenario considered, a second intensity $I_{B2}$ of the biasing current generated by the second biasing current generator 1211 can be expressed as:

$$I_{B2} = I_B \cdot \sin\theta$$

As a result, the output current signal has an output current intensity $I_O$ which can be expressed as:

$$I_o = I_{o1} + I_{o2} = \frac{4I_B}{\pi(2N+1)}\left[\sin\big((2N+1)\omega_0 t\big)\cdot\cos\theta + \cos\big((2N+1)\omega_0 t\big)\cdot\sin\theta\right]$$

Exploiting trigonometric equivalence, the output current intensity $I_O$ of the output signal OUT can be expressed as:

$$I_o = \frac{4I_B}{\pi(2N+1)}\sin\big((2N+1)\omega_0 t + \theta\big)$$

A circuit and method as exemplified facilitate an increased robustness over PVT variations thanks to the use of the biasing current to vary the phase shift.

An arrangement as exemplified in Figure 2 facilitates varying the phase shift $\Theta$ of the output signal OUT within at least one quadrant of the turn angle.

It may be possible to vary the phase shift also in the entire turn angle, that is in a range of linear phase shift angle values from 0° to 360°, for instance by changing sign and amplitude of biasing currents $I_{B1}$, $I_{B2}$.

Figures 4B to 4D are diagrams exemplary of a way of representing the total current $I_O$ as a vector whose orientation in a complex plane is a function of the first and second output signals $I_{O1}$, $I_{O2}$, whose relative orientation varies as a function of the biasing current values $I_{B1}$, $I_{B2}$, as discussed in the foregoing.

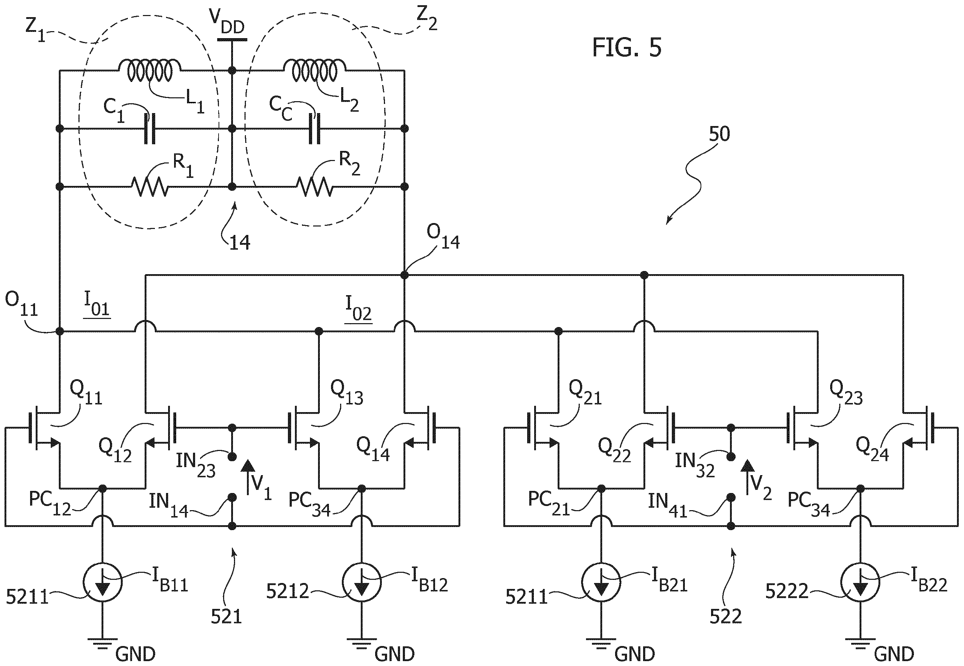

In an alternative scenario exemplified in Figure 5, an alternative circuit 50 for use in the device 10 comprises, in place of the first frequency converter circuit 121 and the second frequency converter circuit 122 in the circuit 20 exemplified in Figure 2:

a first alternative (e.g., double-balanced) frequency converter circuit 521 comprising a Gilbert-cell like arrangement comprising two (pairs of) differential pairs of (e.g., n-channel MOSFET) switches $Q_{11}$, $Q_{12}$, $Q_{13}$, $Q_{14}$, each replicating the arrangement of the first differential pair $M_{11}$, $M_{21}$ exemplified in Figure 2 save for the way in which the control nodes of the switches are driven, as discussed in the following; and

a second alternative (e.g., double-balanced) frequency converter circuit 522 comprising a further Gilbert-cell like arrangement comprising two further (pairs of) differential pairs of (e.g., n-channel MOSFET) switches $Q_{21}$, $Q_{22}$, $Q_{23}$, $Q_{24}$, each replicating the arrangement of the second differential pair $M_{12}$, $M_{22}$ exemplified in Figure 2 save for the way in which the control nodes of the switches are driven, as discussed in the following.

As exemplified in Figure 5, the first alternative frequency converter circuit 521 comprises:

a first differential pair of switches $Q_{11}$, $Q_{12}$ comprising a first switch $Q_{11}$ having a control node $IN_{14}$ coupled to the respective control node of a fourth switch $Q_{14}$ and a first biasing node $PC_{12}$ coupled to the respective biasing node of a second switch $Q_{12}$ having a control node $IN_{23}$ coupled to a respective control node of a third switch $Q_{13}$;

a second differential pair of switches $Q_{13}$, $Q_{14}$ comprising the third switch $Q_{13}$ having the control node $IN_{23}$ coupled to the control node of the second switch $Q_{12}$ in the first differential pair $Q_{11}$, $Q_{12}$ and a second biasing node $PC_{34}$ coupled to the biasing node of the fourth switch $Q_{14}$ having the control node $IN_{14}$ coupled to the respective control node of the first switch $Q_{11}$ in the first differential pair $Q_{11}$, $Q_{12}$;

a first biasing current generator 5211 coupled to the first biasing node $PC_{12}$ of the first differential pair $Q_{11}$, $Q_{12}$ to provide a first biasing current $I_{B11}$ thereto, and

a second biasing current generator 5212 coupled to the second biasing node $PC_{34}$ of the second differential pair $Q_{13}$, $Q_{14}$ to provide a second biasing current $I_{B22}$ thereto.

As exemplified in Figure 5, the second alternative frequency converter circuit 522 comprises:

a third differential pair of switches $Q_{21}$, $Q_{22}$ comprising a fifth switch $Q_{21}$ having a control node $IN_{41}$ coupled to the respective control node of an eight switch $Q_{24}$ and a third biasing node $PC_{21}$ coupled to the respective biasing node of a sixth switch $Q_{22}$ having a control node $IN_{32}$ coupled to a respective control node $IN_{32}$ of a seventh switch $Q_{23}$;

a fourth differential pair of switches $Q_{23}$, $Q_{24}$ comprising the seventh switch $Q_{23}$ having the control node $IN_{32}$ coupled to respective control node $IN_{32}$ of the sixth switch $Q_{22}$ in the third differential pair $Q_{21}$, $Q_{22}$ and a fourth biasing node $PC_{34}$ coupled to the biasing node of the eight switch $Q_{24}$ having the control node $IN_{41}$ coupled to the respective control node $IN_{41}$ of the fifth switch $Q_{21}$ in the third differential pair $Q_{21}$, $Q_{22}$;

a third biasing current generator 5221 coupled to the third biasing node $PC_{21}$ of the third differential pair $Q_{21}$, $Q_{22}$ to provide a third biasing current $I_{B21}$ thereto, and
a fourth biasing current generator 5222 coupled to the fourth biasing node $PC_{34}$ of the fourth differential pair $Q_{23}$, $Q_{24}$ to provide a fourth biasing current $I_{B22}$ thereto.

As exemplified in Figure 5, operating the circuit 50 comprises:

applying a first input signal $V_1$ among the control nodes $IN_{23}$, $IN_{14}$ of the first alternative frequency converter circuit 521,
applying a second input signal $V_2$ (is in quadrature with the first input signal $V_1$) among the control nodes $IN_{32}$, $IN_{41}$ of the second alternative frequency converter circuit 522,
setting the current intensity values $I_{B11}$, $I_{B12}$, $I_{B21}$, $I_{B22}$ of biasing currents generated via the first, second, third and fourth biasing current generators 5211, 5212, 5221, 5222 to produce a phase shift of the output signal.

The alternative circuit 50 exemplified in Figure 5 with respect to the circuit 20 exemplified in Figure 2 facilitates further increasing robustness versus PVT variations thanks to the possibility to have some current generators deactivated in varying the phase shift in a range of linear phase shift angle values 0° to 360°.
For instance, the current intensities $I_{B11}$, $I_{B12}$, $I_{B21}$, $I_{B22}$ for different ranges of phase shift values $\Theta$ may be expressed as:

$$\theta \in [0°, 90°] \leftrightarrow I_{B12} = I_{B22} = 0; I_{B11} = I_B \cdot \cos\theta; I_{B21} = I_B \cdot \sin\theta$$

$$\theta \in [90°, 180°] \leftrightarrow I_{B12} = I_{B21} = 0; I_{B11} = I_B \cdot \cos\theta; I_{B22} = I_B \cdot \sin\theta$$

$$\theta \in [180°, 270°] \leftrightarrow I_{B11} = I_{B21} = 0; I_{B12} = I_B \cdot \cos\theta; I_{B22} = I_B \cdot \sin\theta$$

$$\theta \in [270°, 360°] \leftrightarrow I_{B11} = I_{B22} = 0; I_{B12} = I_B \cdot \cos\theta; I_{B21} = I_B \cdot \sin\theta$$

In other words, based on intensity values of at least one further control signal $I_{B11}$, $I_{B12}$, $I_{B21}$, $I_{B22}$ and at least one control signal $I_{B1}$, $I_{B2}$ being based on the biasing phase shift value $\Theta$ it is possible to alternately apply the input voltages V1, V2, with alternating phases to the differential input nodes IN1, IN2 of the circuit 20, 50. Without being bound to a specific theoretical model, this can be the result of turning alternatively ON and OFF transistors in the differential pairs of transistors as a result of setting at least two control signals at zero intensity/amplitude.
In variant embodiments, it may be possible to vary the four current intensity values $I_{B11}$, $I_{B12}$, $I_{B21}$, $I_{B22}$ as a function of the two parameters $\beta_1$, $\beta_2$ with respect to their sum $I_B$.
For instance, in such an alternative scenario the biasing current intensity values $I_{B11}$, $I_{B12}$, $I_{B21}$, $I_{B22}$ can be expressed as:

$$I_{B11} = I_B - \beta_1; I_{B12} = I_B + \beta_1; I_{B21} = I_B - \beta_2; I_{B22} = I_B + \beta_2$$

where the considerations expressed in the foregoing with reference to Figures 4A-4D can be applied likewise to determine the values of the parameters $\beta_1$, $\beta_2$.
In the considered variant embodiments, to extend the range of applicable phase shift $\Theta$ to at least two quadrants of the turn angle, the values of current intensity parameter $\beta_1$, $\beta_2$ may be expressed as:

$$\theta \in [0°, 90°] \leftrightarrow \beta_1 = \frac{I_B}{\alpha} \cdot \cos\theta; \beta_2 = \frac{I_B}{\alpha} \cdot \sin\theta$$

$$\theta \in [90°, 180°] \leftrightarrow \beta_1 = \frac{I_B}{\alpha} \cdot \cos\theta; \beta_2 = -\frac{I_B}{\alpha} \cdot \sin\theta$$

$$\theta \in [180°, 270°] \leftrightarrow \beta_1 = -\frac{I_B}{\alpha} \cdot \cos\theta \ ; \beta_2 = -\frac{I_B}{\alpha} \cdot \sin\theta$$

$$\theta \in [270°, 360°] \leftrightarrow \beta_1 = -\frac{I_B}{\alpha} \cdot \cos\theta \ ; \beta_2 = \frac{I_B}{\alpha} \cdot \sin\theta$$

where $\alpha$ is a user settable parameter whose value is greater than unity or one.

The circuits 20, 50 as exemplified herein can be integrated circuits, for instance integrated in a 28nm FD-SOI CMOS technology (per se known).

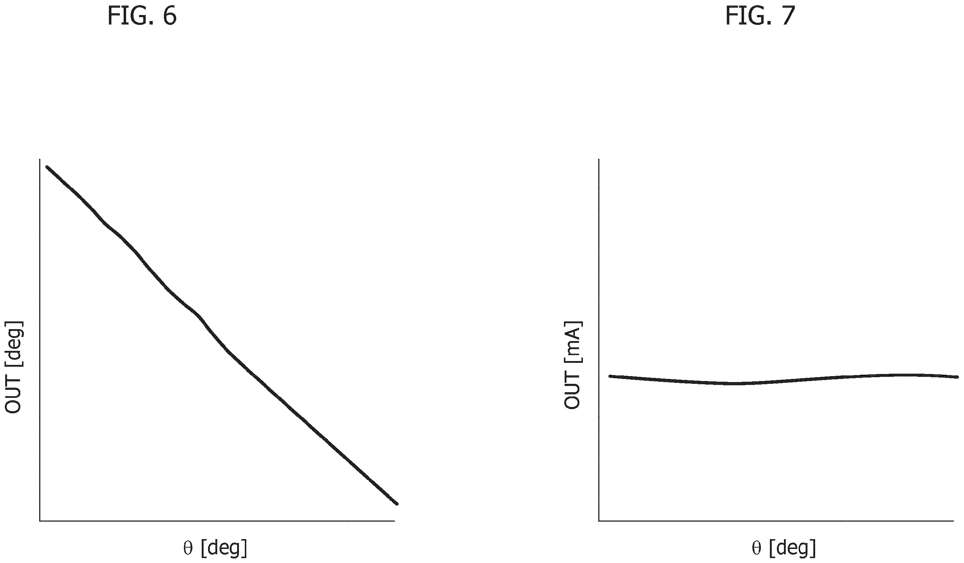

Figure 6 shows a plot of the phase of the output signal OUT provided by the circuits 10, 20, 50 as a function of the phase shift $\Theta$, which is indicative of the linear type relationship among the two parameters.

Figure 7 shows a plot of amplitude of the output signal OUT provided by the device 10 comprising the circuit 20 or 50 as a function of the phase shift $\Theta$, which is indicative of the fact that the amplitude of the signal remains substantially constant during phase-shift variations.

In a method as exemplified herein, providing 14 the further output signal OUT comprises:

providing at least one resonant network stage $R_1$, $L_1$, $C_1$; $R_2$, $C_2$, $L_2$ and tuning the at least one (resonant) network stage to resonate at an odd integer multiple of the input frequency $f_0$ of the first, resp. second, input signal $V_1$, $V_2$, and applying resonant filtering $Z_1$, $Z_2$ to a signal based on the first $O_1$ and the second $O_2$ amplified difference signals, producing the further output (e.g., voltage) signal OUT as a result.

In a first exemplary scenario exemplified in Figure 2, applying said first signal processing 121; 521 and said second signal processing 122; 522 comprises:

providing a first signal amplification processing stage $M_{11}$, $M_{21}$; $Q_{11}$, $Q_{12}$, $Q_{13}$, $Q_{14}$ and a second signal amplification processing stage $M_{12}$, $M_{22}$; $Q_{21}$, $Q_{22}$, $Q_{23}$, $Q_{24}$, the first, resp. second, signal amplification processing stage comprising at least one differential pair of transistors having current flow paths therethrough configured to be made selectively conductive and non-conductive based on the first, resp. second, input signal and having a common biasing node therebetween;
coupling, to the first signal amplification processing stage, a first set of current generators 1210; 5211, 5212 configured to provide the first set of control signals;
coupling, to the second signal amplification processing stage, a first set of current generators 1220; 5221, 5222 configured to provide the second set of control signals.

As exemplified herein, the method comprises:

coupling at least one resonant network stage to the first and to the second signal amplification processing stages;
tuning the at least one network stage to resonate at an odd integer multiple of the input frequency of the first, resp. second, input signal, and
applying resonant filtering to a difference among the first and the second amplified difference signals, producing the further output signal as a result,
wherein the further output signal comprises a voltage signal.

For instance, the method comprises varying said phase shift $\Theta$ within at least one quarter of the turn angle.

As exemplified herein:

the first set of control signals $B_1$ comprises a first plurality of biasing current signals $I_{B11}$, $I_{B12}$;
the second set of control signals $B_2$ comprises a second plurality of biasing current signal $I_{B21}$, $I_{B22}$, and
at least one biasing current signal in first plurality of biasing current signals and at least one biasing current signal in the second plurality of biasing current signal is equal to zero.

As exemplified herein:

the first set of control signals $B_1$ comprises a first biasing current signal $I_{B11}$ and a second biasing current signal $I_{B12}$;
the second set of control signals $B_2$ comprises a third biasing current signal $I_{B21}$ and a fourth biasing current signal $I_{B22}$.

For instance:

the first biasing current signal has a first biasing intensity equal to a common biasing $I_B$ intensity plus a first biasing coefficient $\beta_1$;

the second biasing current signal has a second biasing intensity equal to the common biasing intensity $I_B$ minus the first biasing coefficient $\beta_1$;

the third biasing current signal has a third biasing intensity equal to the common biasing intensity $I_B$ plus a second biasing coefficient $\beta_2$;

the fourth biasing current signal has a fourth biasing intensity equal to the common biasing intensity $I_B$ minus the second biasing coefficient $\beta_2$;

said phase shift $\Theta$ is equal to an arc-tangent of the ratio of the first biasing coefficient $\beta_1$ and the second biasing coefficient $\beta_2$.

As exemplified herein, said first biasing coefficient $\beta_1$ and said second biasing coefficient $\beta_2$ are based on a ratio of the common current intensity $I_B$ and an integer value $\alpha$ greater than one.

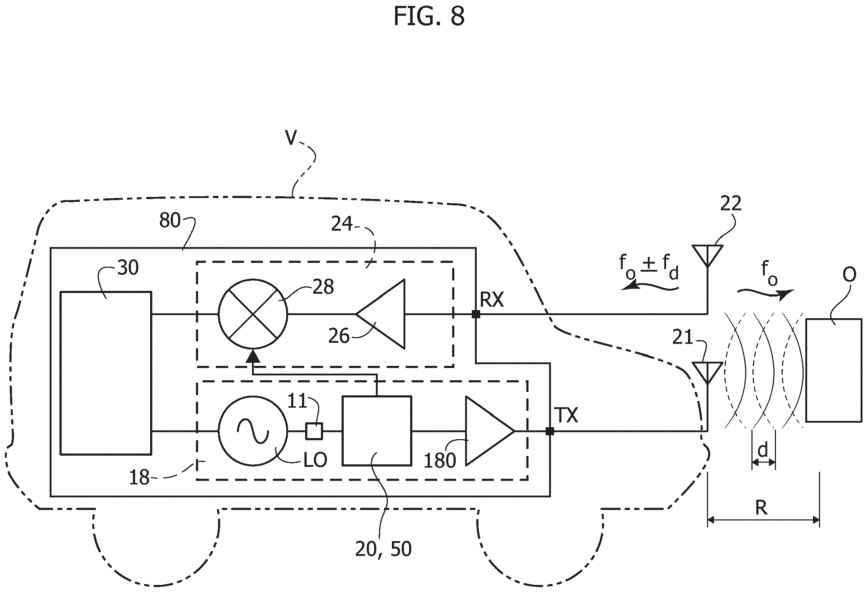

As exemplified in Figure 8, a vehicle V can be equipped with a radar system 80 comprising a device 10 as per the present disclosure and antennas 21, 22 in order to detect an object O, for instance an obstacle along a traveling path of the vehicle V.

Distance R (and speed) of the object O can be detected by measuring a time delay $d$ between a transmitted signal (whose wave-front is shown in solid lines) having a carrier signal frequency $f_0$ and the received echo signal (whose wave-front is shown in dashed lines) having a spectral content $f_0 \pm f_d$ spread over the carrier radio-frequency signal at frequency $f_0$.

As exemplified in Figure 8, a radar transceiver system 80 comprises:

a transmitter chain 18 configured to provide a RF signal to a transmitting antenna (e.g., array) 21,

a receiver chain 24 configured to detect the echo signal reflected from the obstacle O via a receiver antenna (e.g., array) 22,

a processing system 30 configured to drive the transmission of signals from the transmitter chain 18 and to process signals detected by the receiver chain 24.

As exemplified in Figure 8, the transmitter chain 18 comprises:

a frequency synthesizer LO, such as a phase-locked loop (briefly, PLL) configured to generate the first input signal $V_1$ configured to provide a subharmonic of the operating frequency, e.g., to counter frequency pulling from the power amplifier;

a quadrature generator 11 coupled to the frequency synthesizer LO to provide the second input signal $V_2$ as an antiphase or quadrature version of the first input signal $V_1$;

a circuit (implemented in the single 20 or double balanced 50 topologies, for instance) coupled to the frequency synthesizer LO and to the phase-shifter to receive the first $V_1$ and second $V_2$ input signals therefrom, the circuit 20, 50 configured to perform frequency multiplication and to apply a linear phase shift $\Theta$ to the input signals $V_1, V_2$, providing as a result an output signal OUT which comprises an odd harmonic of the RF signal and has a phase shift $\Theta$ which is a function of user-settable parameters $B_1, B_2$;

a (transmitter) amplifier 180, e.g., a variable-gain amplifier (briefly, VGA) or a power amplifier (briefly, PA), coupled to the circuit 20, 50 to receive the (odd) harmonic OUT of the RF signal $V_1$ therefrom, the amplifier 180 configured to amplify the harmonic of the RF signal produced via the circuit 20, 50 and to operate/drive the transmission (briefly, TX) antenna (array) 21 therewith.

As exemplified in Figure 8, the corresponding incoming (echo) signal received at a receiving (briefly, RX) antenna 22 is fed to the receiver chain 24, comprising:

a low noise amplifier (briefly, LNA) 26, coupled to the receiver antenna (e.g., array) 22 to receive the echo signal therefrom, and

a frequency converter stage 28 coupled to the LNA 26 to receive the detected echo signal therefrom and coupled to the PLL to receive the local oscillator signal LO therefrom, the frequency converter stage 28 configured to produce a down-converted frequency signal IF based on the echo signal and the LO signal, in a manner per se known.

In one or more embodiments, the radar system 80 may be a system-on-chip integrated in a semiconductor device. For instance, the proposed system can be integrated in a 28-nm FD-SOI CMOS technology device equipped on-

board a transmitter stage of a mm-wave 77GHz CMOS radar system.

It will be otherwise understood that the various individual implementing options exemplified throughout the figures accompanying this description are not necessarily intended to be adopted in the same combinations exemplified in the figures. One or more embodiments may thus adopt these (otherwise non-mandatory) options individually and/or in different combinations with respect to the combination exemplified in the accompanying figures.

Without prejudice to the underlying principles, the details and embodiments may vary, even significantly, with respect to what has been described by way of example only, without departing from the extent of protection. The extent of protection is defined by the annexed claims.

**Claims**

1. A method, comprising:

   receiving ($IN_1$) a first input signal ($V_1$) oscillating at an input frequency ($f_0$);
   receiving ($PC_1$) a first set of control signals ($B_1$);
   receiving ($IN_2$) a second input signal ($V_2$) oscillating at the input frequency ($f_0$) and in quadrature with the first input signal ($V_1$);
   receiving ($PC_2$) a second set of control signals ($B_2$);
   applying first signal processing (121; 521) to the first input signal ($V_1$) and to control signals in the first set of control signals ($B_1$), providing a first output signal ($O_1$) as a result, the first output signal ($O_1$) oscillating at a first output frequency based on the input frequency ($f_0$) and having an output signal amplitude based on the amplitude of at least one first control signal ($I_{B1}$) in the first set of control signals ($B_1$);
   applying second signal processing (122; 522) to the second input signal ($V_2$) and to control signals in the second set control signals ($B_2$), providing a second output signal ($O_2$) as a result, the second output signal ($O_2$) oscillating at a second output frequency equal to the first output frequency and having an output signal amplitude based on the amplitude of at least one second control signal ($I_{B2}$) in the second set of control signals ($B_2$);
   based on the first output signal ($O_1$) and the second output signal ($O_2$), providing (14) a further output signal (OUT) oscillating at an output signal frequency equal to the first output frequency and having a phase shift based on a ratio of signal amplitudes of at least one control signal ($I_{B1}$) in said first set of control signals ($B_1$) and of at least one control signal ($I_{B2}$) in said second set of control signals ($B_2$).

2. The method of claim 1, wherein:

   control signals in the first ($B_1$) and second ($B_2$) set of control signals comprise biasing current signals ($I_{B1}$, $I_{B2}$), and the further output signal (OUT) has a phase shift ($\Theta$) based on a ratio of current intensities of at least one biasing current signal ($I_{B1}$) in said first set of control signals ($B_1$) and of at least one biasing current signal ($I_{B2}$) in said second set of control signals ($B_2$).

3. The method of claim 1, wherein providing (14) the further output signal (OUT) comprises:

   providing at least one resonant network stage ($R_1$, $L_1$, $C_1$; $R_2$, $C_2$, $L_2$) and tuning the at least one network stage ($R_1$, $L_1$, $C_1$; $R_2$, $C_2$, $L_2$) to resonate at an odd integer multiple of the input frequency ($f_0$) of the first, resp. second, input signal ($V_1$, $V_2$), and
   applying resonant filtering ($Z_1$, $Z_2$) to a signal based on the first ($O_1$) and the second ($O_2$) amplified difference signals, producing the output voltage signal (OUT) as a result.

4. The method of any one of the previous claims, wherein applying said first signal processing (121; 521) and said second signal processing (122; 522) comprises:

   providing a first signal amplification processing stage ($M_{11}$, $M_{21}$; $Q_{11}$, $Q_{12}$, $Q_{13}$, $Q_{14}$) and a second signal amplification processing stage ($M_{12}$, $M_{22}$; $Q_{21}$, $Q_{22}$, $Q_{23}$, $Q_{24}$), the first ($M_{11}$, $M_{21}$; $Q_{11}$, $Q_{12}$, $Q_{13}$, $Q_{14}$), resp. second ($M_{12}$, $M_{22}$; $Q_{21}$, $Q_{22}$, $Q_{23}$, $Q_{24}$), signal amplification processing stage comprising at least one differential pair of transistors having current flow paths therethrough configured to be made selectively conductive and non-conductive based on the first ($V_1$), resp. second ($V_2$), input signal and having a common biasing node ($PC_1$, $PC_2$; $PC_{12}$, $PC_{34}$, $PC_{21}$, $PC_{14}$) therebetween;
   coupling, to the first signal amplification processing stage ($M_{11}$, $M_{21}$; $Q_{11}$, $Q_{12}$, $Q_{13}$, $Q_{14}$), a first set of current generators (1210; 5211, 5212) configured to provide the first set of control signals ($B_1$);

coupling, to the second signal amplification processing stage ($M_{12}$, $M_{22}$; $Q_{21}$, $Q_{22}$, $Q_{23}$, $Q_{24}$), a second set of current generators (1220; 5221, 5222) configured to provide the second set of control signals ($B_2$).

5. The method of claim 4, comprising:

coupling at least one resonant network stage ($R_1$, $L_1$, $C_1$; $R_2$, $L_2$, $C_2$) to the first ($M_{11}$, $M_{21}$; $Q_{11}$, $Q_{12}$, $Q_{13}$, $Q_{14}$) and to the second ($M_{12}$, $M_{22}$; $Q_{21}$, $Q_{22}$, $Q_{23}$, $Q_{24}$) signal amplification processing stages;
tuning the at least one network stage ($R_1$, $L_1$, $C_1$; $R_2$, $C_2$, $L_2$) to resonate at an odd integer multiple of the input frequency ($f_0$) of the first, resp. second, input signal ($V_1$, $V_2$), and
applying resonant filtering ($Z_1$, $Z_2$) to a difference among the first ($O_1$) and the second ($O_2$) amplified difference signals, producing the output signal (OUT) as a result,
wherein the further output signal (OUT) comprises a voltage signal.

6. The method of any one of the previous claims, comprising varying said phase shift ($\Theta$) within at least one quarter of the turn angle.

7. The method of any one of the previous claims, wherein:

the first set of control signals ($B_1$) comprises a first plurality of biasing current signals ($I_{B11}$, $I_{B12}$);
the second set of control signals ($B_2$) comprises a second plurality of biasing current signal ($I_{B21}$, $I_{B22}$), and
at least one biasing current signal in first plurality of biasing current signals ($I_{B11}$, $I_{B12}$) and at least one biasing current signal in the second plurality of biasing current signal ($I_{B21}$, $I_{B22}$) is equal to zero.

8. The method of any one of claims 1 to 6, wherein:

the first set of control signals ($B_1$) comprises a first biasing current signal ($I_{B11}$) and a second biasing current signal ($I_{B12}$);
the second set of control signals ($B_2$) comprises a third biasing current signal ($I_{B21}$) and a fourth biasing current signal ($I_{B22}$),
wherein:

the first biasing current signal ($I_{B11}$) has a first biasing intensity equal to a common biasing $I_B$ intensity plus a first biasing coefficient $\beta_1$;
the second biasing current signal ($I_{B12}$) has a second biasing intensity equal to the common biasing intensity $I_B$ minus the first biasing coefficient $\beta_1$;
the third biasing current signal ($I_{B21}$) has a third biasing intensity equal to the common biasing intensity $I_B$ plus a second biasing coefficient $\beta_2$;
the fourth biasing current signal ($I_{B22}$) has a fourth biasing intensity equal to the common biasing intensity $I_B$ minus the second biasing coefficient $\beta_2$;
said phase shift ($\Theta$) is equal to an arc-tangent of the ratio of the first biasing coefficient $\beta_1$ and the second biasing coefficient $\beta_2$.

9. The method of claim 8, wherein said first biasing coefficient $\beta_1$ and said second biasing coefficient $\beta_2$ are based on a ratio of the common current intensity $I_B$ and an integer value $\alpha$ greater than one.

10. A circuit (20; 50), comprising:

a first set of input nodes ($IN_{11}$, $IN_{21}$; $IN_{23}$, $IN_{14}$) configured to receive ($IN_1$) a first input signal ($V_1$) oscillating at an input frequency ($f_0$);
a first set of control nodes ($PC_1$; $PC_{12}$, $PC_{34}$) configured to receive ($PC_1$) a first set of control signals ($B_1$);
a second set of input nodes ($IN_{12}$, $IN_{22}$) configured to receive ($IN_2$) a second input signal ($V_2$) oscillating at the input frequency ($f_0$) and in quadrature with the first input signal ($V_1$);
a second set of control nodes ($PC_2$; $PC_{21}$, $PC_{34}$) configured to receive ($PC_2$) a second set of control signals ($B_2$);
signal processing circuitry (121, 122; 521, 522) coupled to the first set of input nodes ($IN_{11}$, $IN_{21}$; $IN_{23}$, $IN_{14}$), to the first set of control nodes ($PC_1$; $PC_{12}$, $PC_{34}$), to the second set of input nodes ($IN_{12}$, $IN_{22}$; $IN_{32}$, $IN_{41}$) and to the second set of control nodes ($PC_2$; $PC_{21}$, $PC_{34}$),
wherein the signal processing circuitry (121, 122; 521, 522) is configured to provide (14) a further output signal (OUT) according to the method of any one of claims 1 to 9, the further output signal (OUT) oscillating at an output signal frequency equal to the first output frequency and having a phase shift based on a ratio of signal amplitudes of at least one first control signal ($I_{B1}$) in said first set of control signals ($B_1$) and of at least one second control signal ($I_{B2}$) in said second set of control signals ($B_2$).

11. A device, comprising:

a circuit (20; 50) according to claim 10;
a frequency synthesizer (LO, 11) coupled to the circuit (20; 50) and configured to provide thereto the input signals ($V_1$, $V_2$) oscillating at the input frequency ($f_0$).

12. The device according to claim 11, wherein the frequency synthesizer (11) is configured to provide said input signals ($V_1$) oscillating at the input frequency ($f_0$) such that the output frequency of the further output signal (OUT) lies in the millimeter wavelength range.

13. A system (10, 18), comprising:

a device (10) according to claim 9 or claim 11 or claim 12;
a power amplifier (180) coupled to the circuit (10; 20, 50) and configured to receive the further output signal (OUT) therefrom, the power amplifier (180) configured to amplify the further output signal (OUT) and to provide an amplified output signal (TX) as a result, and
a transmitter antenna (20) coupled to the power amplifier (180) and configured to transmit the amplified output signal (TX).

14. The system (10, 18) of claim 13, including a vehicular radar system comprising:

a receiver antenna (22) configured to receive an echo signal based on the transmitted amplified output signal (TX),
a mixer stage (28) coupled to the circuit (10; 20; 50), the mixer stage (28) configured to apply frequency mixing to further output signal (OUT) and to the echo signal, producing a mixed signal as a result.

15. A vehicle (V) equipped with a vehicular radar system (10) according to claim 14.

FIG. 1

FIG. 2

FIG. 3A

FIG. 3B

FIG. 3C

EP 4 502 647 A1

FIG. 4B

$I_O$

$I_{O2}$

$I_{O1}$

FIG. 4D

$I_O$

$I_{O1}$

$I_{O2}$

FIG. 4A

$I_O$

$I_{O2}$

$I_{O1}$

FIG. 4C

$I_{O1}$

$I_{O2}$

$I_O$

FIG. 5

FIG. 7

OUT [mA]

θ [deg]

FIG. 6

OUT [deg]

θ [deg]

# FIG. 8

EP 4 502 647 A1

Europäisches
Patentamt

European
Patent Office

Office européen
des brevets

# EUROPEAN SEARCH REPORT

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2017/019067 A1 (CHAKRABORTY SUDIPTO [US]) 19 January 2017 (2017-01-19) | 1,2,4, 6-15 | INV.<br>G01S7/35 |
| Y | * paragraphs [0006], [0007], [0045], [0030]; figures 1-3 * | 3,5 | G01S13/931<br>G01S13/42<br>H03B27/00 |
| Y | US 5 939 918 A (MCGARRY STEVEN PAUL [CA] ET AL) 17 August 1999 (1999-08-17)<br>* figure 1 * | 3,5 | H03D7/14<br>H03F3/45<br>H03H11/16<br>H03K5/13 |

TECHNICAL FIELDS
SEARCHED      (IPC)

G01S
H03D
H03K
H03H
H03F
H03B

The present search report has been drawn up for all claims

| Place of search | Date of completion of the search | Examiner |
|---|---|---|
| Munich | 25 November 2024 | Ferrara, Michele |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons

.............................................................................................
& : member of the same patent family, corresponding
    document

EPO FORM 1503 03.82 (P04C01)

## ANNEX TO THE EUROPEAN SEARCH REPORT
## ON EUROPEAN PATENT APPLICATION NO.

EP 24 18 3082

25-11-2024

| Patent document cited in search report | Publication date | Patent family member(s) | | Publication date |
|---|---|---|---|---|
| US 2017019067 A1 | 19-01-2017 | CN | 106357274 A | 25-01-2017 |
| | | US | 2017019067 A1 | 19-01-2017 |
| US 5939918 A | 17-08-1999 | EP | 0926821 A2 | 30-06-1999 |
| | | US | 5939918 A | 17-08-1999 |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **M. JUNG** ; **B. -W. MIN**. A Compact Ka-Band 4-bit Phase Shifter With Low Group Delay Deviation. *IEEE Microwave and Wireless Components Letters*, April 2020, vol. 30 (4), 414-416
- **W. H. WOODS** ; **A. VALDES-GARCIA** ; **H. DING** ; **J. RASCOE**. CMOS millimeter wave phase shifter based on tunable transmission lines. *Proceedings of the IEEE 2013 Custom Integrated Circuits Conference, San Jose, CA, USA*, 2013, 1-4
- **S. KISHIMOTO** ; **I. ANDO** ; **M. KOHTANI** ; **N. HASEGAWA** ; **T. ARAI** ; **S. YAMAURA**. A 79GHz 13.5dBm P sat at 150° C transmitter with compact local phase shifter in 40nm CMOS for automotive radar. *Proc. IEEE 20th Topical Meeting Silicon Monolithic Integr. Circuits RF Syst. (SiRF)*, 2020, 66-69

- **SHIMURA, TOSHIHIRO et al.** A 76-81 GHz active phase shifter for phased array automotive radar in 65nm CMOS. *2013 European Microwave Integrated Circuit Conference*, 2013, 252-255
- **F. AKBAR** ; **A. MORTAZAWI**. A frequency tunable 350° analog CMOS phase shifter with an adjustable amplitude. *IEEE Transactions on Circuits and Systems II: Express Briefs*, December 2017, vol. 64 (12), 1427-1431
- **B. DOU et al.** A 4-10 GHz Programmable CMOS Vector-Sum Phase Shifter for a Two-Channel Transmitter. *IEEE Transactions on Circuits and Systems II: Express Briefs*, September 2022, vol. 69 (9), 3699-3703